# DEMANDE DE BREVET EUROPEEN

(11) **EP 0 619 645 A1**
(43) Date de publication de la demande: **12.10.1994**
(21) Numéro de dépôt: 94400543.8
(22) Date de dépôt: 14.03.1994
(51) Int. Cl.: H03B 5/36

(54) **Montage à réponse linéarisée et symétrisée, oscillateur utilisant un tel montage et émetteur de télécommande utilisant un tel oscillateur**

(30) Priorité: 05.04.1993 FR 9303990
(71) Demandeur: VALEO ELECTRONIQUE, 94042 Creteil Cédex (FR)
(72) Inventeur: Rydel, Charles, F-75019 Paris (FR)
(74) Mandataire: Gamonal, Didier

(57) **Abrégé**

La présente invention concerne un montage électronique à réponse linéarisée et symétrisée. Elle concerne aussi un oscillateur à faible taux d'harmoniques. Elle trouve application notamment dans un émetteur de signaux de télécommande.

Selon l'invention, on dispose un dispositif de linéarisation et de symétrisation de la réponse de l'amplificateur (18) d'un oscillateur harmonique (16), disposé à la sortie d'un organe générateur ds mots de télécommande (11 - 15) de façon à réduire le taux d'harmoniques.

## Description

La présente invention concerne un montage électronique à réponse linéarisée et symétrisée. Elle concerne aussi un oscillateur à faible taux d'harmoniques. Elle trouve application notamment dans un émetteur de signaux de télécommande.

Dans l'état de la technique, on connaît des montages dont le point de fonctionnement est choisi dans une zone linéaire de la caractéristique tension-courant. De cette manière on sait produire des réponses qui sont sensiblement proportionnelles à la grandeur d'entrée du montage. Un tel montage électronique peut être de tout type comprenant :
- les transformateurs d'impédances ;
- les transformateurs d'admittances ;
- les amplificateurs en tension ou en courant ;
- les oscillateurs.

Cependant, les montages électroniques de l'art antérieur ne sont pas satisfaisant particulièrement quand on cherche à équiper un appareil portable dont la source d'alimentation est de stabilité médiocre. En particulier dans ce cas, il est difficile de réduire l'étalement du spectre rayonné de façon parasite par le montage électronique ans ajouter des filtres qui en augmentent la complexité, les risques de divergence thermique et le prix.

C'est un objet de l'invention de porter remède à cet inconvénient de l'art antérieur.

On a déjà proposé des montages électroniques permettant de produire des ondes sinusoïdales sous le nom d'oscillateurs harmoniques.

De tels oscillateurs sont déjà connus comme produisant un faible taux d'harmoniques, et en ce qu'ils produisent, à leur fréquence de fonctionnement stable, un signal réputé contenir moins d'harmoniques que les oscillateurs d'autres types comme les oscillateurs en relaxation.

Cependant, on sait que les oscillateurs harmoniques produisent un certain taux d'harmoniques en particulier lorsqu'ils passent du régime de démarrage au régime permanent, mais aussi en régime permanent.

Dans l'état de la technique, on a déjà proposé de symétriser les montages oscillateurs, la symétrisation du montage par rapport à un potentiel de référence, comme dans un montage de type push pull, permettant d'éliminer les harmoniques d'ordre pair et de renforcer l'harmonique à la fréquence de travail.

Cependant, l'encombrement du spectre fréquentiel en particulier dans le spectre des radiofréquences est devenu tel que les normes exigent des affaiblissements au delà de la fréquence de travail, en harmonique 1, donc d'ordre impair, toujours plus importants.

En particulier, la présente invention est destinée à un émetteur de signaux de télécommande comme un émetteur de télécommande fonctionnant dans les radiofréquences, qui comporte un moyen produisant un mot de code constitué d'une pluralité de signaux en forme de créneaux. Chaque créneau dure un temps prédéterminé pendant lequel un oscillateur harmonique est activé.

Pendant la durée d'activation, l'oscillateur doit monter à sa fréquence de fonctionnement stable aussi rapidement que possible, et s'y maintenir sans générer d'harmoniques élevées de façon à ne pas polluer l'environnement électromagnétique.

Dans cette disposition, on voit que la génération d'harmoniques élevées est encore plus forte que pour des montages fonctionnant en permanence, en particulier parce que la durée des créneaux peut être aussi brève que 10 microsecondes. De ce fait, on produit une modulation de fréquences qui peut se prolonger dans le spectre.

Une solution consiste à faire suivre l'oscillateur harmonique, symétrisé ou non, par un filtre passe-bas qui affaiblit considérablement les harmoniques à partir de 2.Ft, si Ft est la fréquence de travail de l'oscillateur harmonique, c'est à dire le premier harmonique.

Mais cette solution conduit à une augmentation des moyens, donc à de nombreux inconvénients qui s'en suivent comme :
- l'augmentation de la complexité du circuit, qui rend son intégration plus difficile ;
- l'augmentation des possibilités de divergences au vieillissement ou aux agressions comme la température;
- l'augmentation de la susceptibilité électromagnétique ;
- l'augmentation du coût.

C'est un autre objet de l'invention de proposer un nouveau genre d'oscillateurs, et particulièrement d'oscillateurs harmoniques qui sont dégagés des défauts précités.

C'est un autre objet de l'invention de produire un émetteur de télécommande produisant un signal de télécommande ou de transmission particulièrement pur et stable.

Selon l'invention, le montage électronique comporte dans l'un de ses réseaux d'entrée ou de sortie, ou dans un chemin de rétroaction entre ses deux réseaux un dispositif linéarisateur et symétriseur constitué par deux composants dont les fonctions de transfert sont sensiblement inverses l'une de l'autre et qui sont connectées de façon à ce que la fonction de transfert résultante présente près du point de fonctionnement du montage un point d'inflexion autour duquel une plage linéaire est produite.

L'invention concerne un oscillateur, comme un oscillateur harmonique qui comporte principalement :
- un étage amplificateur ;
- un réservoir d'énergie résonnant comme un circuit accordé ;
- une boucle de rétraoaction qui renvoie une fraction prédéterminée de l'énergie stockée à l'entrée de l'amplificateur.

L'invention se caractérise en ce que la boucle de rétroaction comporte un dispositif linéarisateur et symétriseur constitué par deux composants dont les fonctions de transfert sont sensiblement inverses l'une de l'autre et qui sont connectées de façon à ce que la fonction de transfert résultante présente près du point de fonctionnement du montage un point d'inflexion autour duquel une plage linéaire est produite.

Selon une variante de l'invention, une partie du circuit accordé constitue un filtre passe-bas dont la sortie constitue la sortie de l'oscillateur.

L'invention concerne aussi un émetteur de télécommande, destiné notamment à faire fonctionner à distance un appareil doté d'un récepteur convenable, en particulier de type radiofréquence, mais non nécessairement.

Un tel émetteur est plus particulièrement adapté à la télécommande de verrouillage/déverrouillage des ouvrants et/ou d'organes de blocage de système antivol et/ou d'une alarme de véhicule.

L'émetteur de télécommande se caractérise en ce qu'il comporte un générateur de signal de modulation dont la sortie est connectée à l'entrée de l'amplificateur d'un oscillateur harmonique, dont la sortie est couplée à un organe rayonnant comme une antenne radiofréquence.

L'invention se caractérise en ce que l'émetteur comporte un oscillateur harmonique selon l'invention.

Selon un mode de réalisation, l'oscillateur harmonique est de type Hartley.

Selon un autre mode de réalisation, l'oscillateur harmonique est de type Colpits.

Selon un autre mode de réalisation, la boucle de rétroaction est connectée entre la sortie du circuit résonnant et la base d'un transistor d'entrée de l'amplificateur.

Selon un autre mode de réalisation, la boucle de rétroaction est connectée entre la sortie du circuit résonnant et l'émetteur d'un transistor de l'amplificateur.

Dans un mode de réalisation, le montage est destiné à exciter une source de rayonnement optique ou acoustique comme un rayonnement ultrasonore.

Dans un autre mode de réalisation, le montage est destiné à exciter une source de rayonnement radiofréquence, ou un signal électrique transmis sur une ligne filaire ou autrement.

D'autres caractéristiques et avantages de la présente invention seront mieux compris à l'aide de la description et des dessins qui sont :
- la figure 1 : un schéma d'un dispositif selon l'invention ;
- les figures 2a à 2c : des caractéristiques ctension- courant selon l'invention
- la figure 3 : un premier mode de réalisation d'un dispositif selon l'invention ;
- la figure 4 : un second mode de réalisation d'un dispositif selon l'invention ;
- la figure 5 : un schéma de principe d'un oscillateur harmonique selon l'état de la technique ;
- la figure 6 : un schéma de principe d'un oscillateur harmonique selon la présente invention ;
- la figure 7 : un schéma électrique d'un émetteur de télécommande équipé d'un oscillateur de type Colpits dans lequel on a implémenté l'invention ;
- la figure 8 : un schéma d'une variante d'une partie du circuit de la figure 7 ;
- la figure 9 : une application du dispositif de la figure 3 au montage de la figure 7.

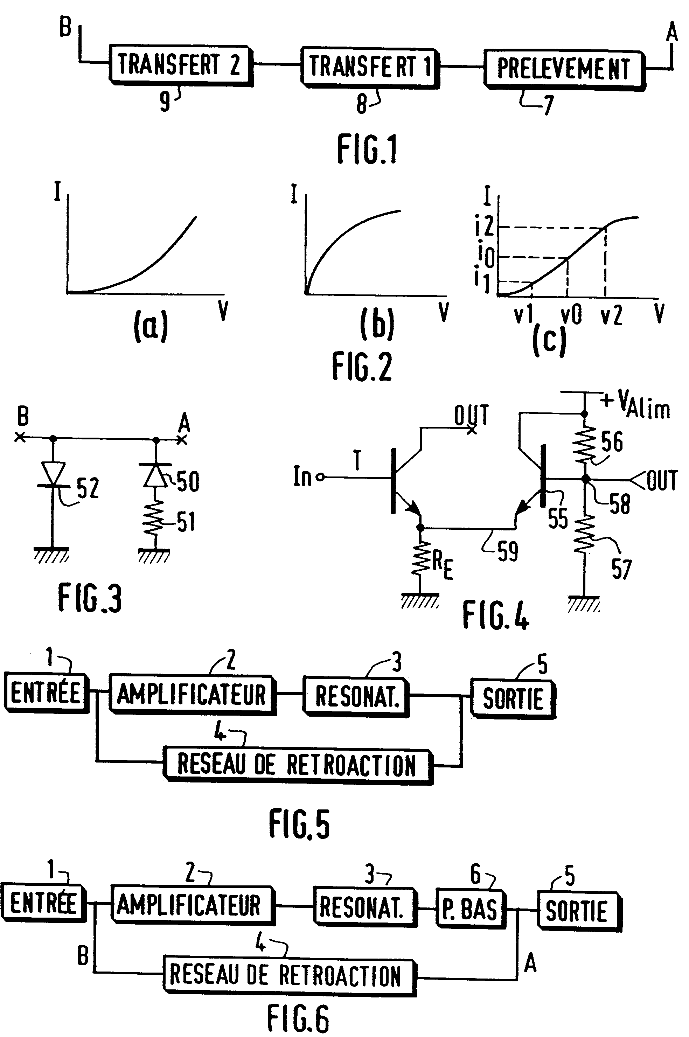

A la figure 1, on a représenté un dispositif linéarisateur et symétriseur selon l'invention.

Le signal à transformer est prélevé en A sur un point prédéterminé du montage électronique par l'intermédiaire d'un moyen de prélèvement 7 qui permet ou bien de sélectionner tout le signal ou une partie de celui-ci ou bien de réaliser les adaptations nécessitées par l'introduction du dispositif dans le montage.

La sortie du moyen de prélèvement 7 est connectée à l'entrée d'un premier composant 8 qui est représenté par une première fonction de transfert avec une caractéristique tension-courant déterminée.

La sortie du premier composant 8 est connectée à l'entrée d'un second composant 9 qui est représenté par une seconde fonction de transfert avec une caractéristique tension-courant déterminée.

La sortie du second composant 9 est réinjectée à un point B prédéterminé du montage.

Le choix des points A et B dépend de la fonction que l'on veut linéariser. Sa sélection est à la portée de l'homme de métier en fonction du problème qu'il veut résoudre en utilisant le dispositif de l'invention. Les points A et B peuvent être sur un port d'entrée du montage, sur un port de sortie du montage ou encore en série dans une boucle de rétroaction entre le port d'entrée et le port de sortie du montage électronique.

Aux Figures 2a à 2c on a représenté des caractéristiques tension-courant du dispositif de la figure 1 qui permettent d'atteindre l'objectif de l'invention.

A la figure 2a, la caractéristique tension-courant du premier composant 8 affecte une forme monotone croissante dont la dérivée dI/dV augmente avec V.

A la figure 2b, la caractéristique tension-courant du second composant 9 affecte une forme monotone croissante dont la dérivée dI/dV diminue avec V.

En connectant de manière convenable les deux composants 8 et 9, on conçoit que la caractéristique tension-courant résultante, représentée à la figure 2c, présente un point d'inflexion au lieu où les effets des deux composants s'équilibrent. En un tel point, correspondant à une tension V0 et à un courant I0, que l'on choisira comme point de fonctionnement central du montage électronique corrigé, on se trouve au centre d'une zone sensiblement linéaire de la caractéristique comprise entre les tensions V1, V2 et les courants correspondants i1, i2.

Dans ce domaine de variation, le montage aura une réponse linéarisée.

De plus, comme les dérivées des deux fonctions de transert varient, il est clair que les deux extrémités de la caractéristique résultante peuvent présenter une pente réduite ou nulle qui indique un effet d'écrêtage qui limite les distorsions de façon automatique.

D'autre part, on remarque que le choix convenable de deux composants réciproques, comme deux diodes montées en inverse l'une de l'autre, ou comme une diode et une jonction base-émetteur, permet d'obtenir une réponse symétrique de part et d'autre du point d'inflexion v0, i0.

Les caractéristiques choisies ici sont en tension-courant, mais selon le type du montage les autres caractéristiques sont modifiables dans les mêmes conditions.

A la Figure 3, on a représenté un premier mode de réalisation d'un dispositif linéarisateur et symétriseur selon l'invention.

Le dispositif comporte un premier composant constitué par une diode 50 dont l'anode est connectée à une première borne d'une résistance 51 et dont la cathode est connectée à l'entrée A.

Le dispositif comporte comme second composant une diode 53, identique à la première diode 50, et connectée dans le sens inverse de celui de la première diode entre la masse et la sortie B. Sortie et entrée sont reliées ensemble.

Le fonctionnement du dispositif sera décrit dans son application à un émetteur de télécommande équipé d'un oscillateur harmonique linéarisé et symétrisé plus loin.

A la figure 4, on a représenté un second mode de réalisation du dispositif de l'invention dans lequel le premier composant du dispositif est constitué par un transistor 55 de type NPN ajouté à un transistor NPN sensiblement identique, et déjà existant dans le montage électronique, de telle sorte que les deux transistors sont montés en différentiel pour présenter une jonction émetteur-collecteur en inverse de la jonction émetteur-collecteur du transistor existant 56.

A cet effet, le second transistor est polarisé par un pont de résistances 56 et 57 disposées entre la borne positive de l'alimentation +Valim et la masse. Son entrée est connectée à la sortie OUT du premier transistor T, déjà existant. Sa sortie est prise sur son émetteur qui est lui-même connecté comme pour constituer un amplificateur différentiel sur l'émetteur du transistor T. Le transistor T est connecté à la masse par une résistance d'émetteur RE.

De cette manière, les deux jonctions émetteur-collecteur des transistors 55 et T s'opposent et produisent l'effet désiré dans le cadre d'une rétroaction en courant de la sortie du transistor T sur son émetteur. La réponse du montage est linéarisée et symétrisée autour du point de fonctionnement selon l'enseignement de la figure 2c.

A la figure 5, on a représenté le schéma de principe d'un oscillateur harmonique. Un tel oscillateur comporte un étage d'entrée 1 connecté à l'entrée d'un amplificateur 2 qui sert à regénérer l'énergie consommée par l'oscillateur lui-même en prélevant de l'énergie sur une source d'énergie non représentée.

La sortie de l'amplificateur 2 est connectée à l'entrée d'un circuit résonnant 3, par exemple constitué à partir d'une inductance et de condensateurs, qui sert de réservoir d'énergie. Le circuit résonnant peut prendre des formes variées comme les structures Colpits ou Hartley, ou d'autres encore bien connues. Un tel résonateur comporte des réactances qui permettent de stocker de l'énergie réactive.

La sortie du résonateur 3 est connectée à un dispositif de sortie 5 et à l'entrée d'une boucle de rétroaction qui prélève une partie de l'énergie résonnante sur le circuit résonnant 3 et le renvoie dans le réseau d'entrée de l'amplificateur.

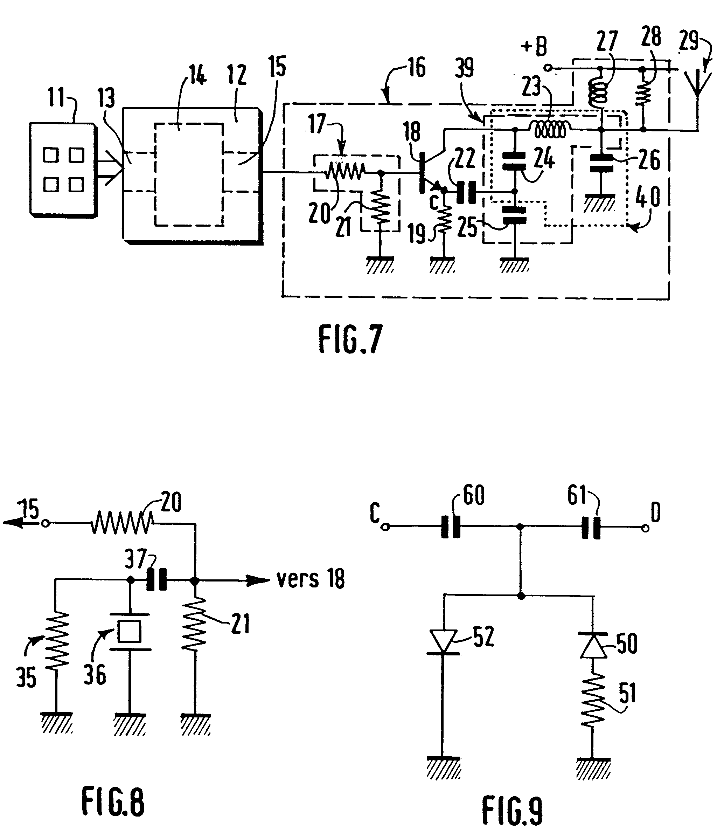

A la Figure 6, on a représenté un oscillateur harmonique équipé du dispositif de linéarisation et de symétrisation de l'invention.

De plus, dans une demande antérieure, le demandeur a déjà déposé une demande de brevet pour protéger un nouveau moyen de filtrage passe-bas permmettant d'améliorer la pureté spectrale d'un oscillateur harmonique. Le moyen qui permet d'atteindre ce résultat est une modification d'un montage existant, et plus particulièrement de son dimensionnement, de façon à produire un filtrage passe-bas au-delà du premier harmonique. Le circuit résonnant comporte lui-même des éléments inductifs et capacitifs qui permettent de constituer un filtre passe-bas qui sert à produire non pas une sortie d'oscillateur filtrée par un dispositif supplémentaire, comme c'est le cas si on applique l'enseignement de l'art antérieur, mais à filtrer directement la sortie du circuit résonnant en l'empêchant de résonner, ou à tout le moins en limitant sa puissance de résonnance dans les hautes fréquences.

Le réseau de rétroaction 4, qui est connecté à la sortie du filtre passe-bas, permet de multiplier les effets du filtrage et de ce fait, améliore la pureté du spectre de sortie de l'oscillateur.

De plus, le réseau de rétroaction est modifié à l'aide du dispositif linéarisateur et symétriseur de l'invention qui est inséré en série dans la boucle 4 selon l'enseignement précédent.

De ce fait, la réponse de l'oscillateur harmonique étant symétrique et linéaire n'engendre pratiquement pas d'harmoniques paires ce qui ne rend pas absolument nécesaire la disposition du filtre passe-bas 6 de la figure 6. Cependant, la disposition concurrente du filtre 6 permet de conserver un degré de souplesse supplémentaire pour le dimensionnement des paramètres de l'oscillateur harmonique.

A la Figure 7, on a représenté un circuit représentant un émetteur de télécommande mettant en oeuvre un oscillateur harmonique modifié selon le concept de l'invention.

L'émetteur comporte un microcontrôleur 12 dont un port d'entrée 13 décode un clavier de télécommande 11. Quand l'utilisateur produit un enfoncement d'une touche, ou d'une séquence de touches du clavier, ou quand l'utilisateur produit une commande prédéterminée, le port d'entrée 13 est placé dans un état déterminé qui est décodé par un programme implanté 14 dans le microcontrôleur 12.

Le programme 14 exécute ensuite une routine de codage d'un signal de télécommande sous la forme d'une série de créneaux de tensions entre 0 et 3 Volts par exemple, de durées prédéterminées. Chaque créneau est produit par un port de sortie 15 du microcontrôleur 12, qui sert d'étage d'entrée d'un oscillateur harmonique 16 selon l'invention.

L'oscillateur 16 comporte un étage d'entrée 17, qui, dans un mode de réalisation, comporte une première résistance 20 connectée entre l'entrée de l'oscillateur et l'entrée de l'amplificateur 18, et une seconde résistance 21 connectée entre l'entrée de l'amplificateur 18 et la masse électrique du montage.

Dans une variante, représentée à la figure , on ajoute au réseau d'entrée 17, un dispositif de contrôle comportant un cristal résonnant 36, comme un filtre résonateur à ondes acoustique de surface, en parallèle avec une résistance 35 de façon à produire un générateur de tension de référence qui est connecté aussi à l'entrée de l'amplificateur 18, éventuellement par l'intermédiaire d'une liaison capacitive, constitué par un condensateur 37. Ce type de montage permet d'asservir l'oscillateur harmonique sur une fréquence de résonnace stable produite par le cristal.

En revenant à la figure 7, on a représenté ensuite l'amplificateur de l'oscillateur harmonique 17, qui est ici constitué par un transistor NPN 18 dont la base est connectée à la sortie du réseau d'entrée 17, et dont l'émetteur est connecté à la masse électrique par l'intermédiaire d'une résistance 19. D'autre part, la sortie de l'amplificateur est constituée par le collecteur du transistor 18 et est connecté à l'entrée du circuit servant de réservoir d'énergie constitué par un circuit résonnant qui comporte une première branche constituée de deux condensateurs en série 24, 25, et d'une seconde branche constituée d'une inductance 23.

Dans une variante de l'invention, qui correspond à la demande précitée, le circuit résonnant, représenté entouré d'un tiret 39, est complété par un condensateur 26 connecté entre une extrémité de l'inductance 23 et la masse. Ainsi connecté, ce condensateur 26 constitue avec l'inductance 23 et le condensateur 24, un filtre passe-bas en "PI", représenté entouré d'une ligne de points 40.

La sortie 27 - 28 de l'oscillateur est connectée sur la polarité +B d'une source d'alimentation continue tel qu'un accumulateur ou une pile au lithium, par l'intermédiaire d'une résistance 28. L'étage de sortie comporte d'autre part une antenne de rayonnement radiofréquence accordée 29 qui émet le rayonnement filtré produit par l'oscillateur.

La boucle de rétroaction est ici constituée par une liaison capacitive, comportant un simple condensateur 22, connectée au point commun entre les deux condensateurs 24 et 25 d'une part, et au point commun entre l'émetteur du transistor 18 et sa résistance d'émetteur 19. La boucle de rétroaction de l'oscillateur harmonique est ici assurée grâce à la jonction base-émetteur du transistor 18, ce qui nécessite que la connexion entre le circuit résonnant 23 - 26 et l'émetteur soit assurée par un condensateur 22.

Dans d'autres modes de réalisation, la boucle de rétroaction est fermée sur la base du transistor 18 par l'intermédiaire d'un condensateur de liaison.

En appliquant le dispositif linéarisateur et symétriseur de l'invention, on remplace le condensateur de liaison 22 par deux condensateurs 60 et 61, représentés à la figure 9, en série dont le point commun est connecté au point A du dispositif de la figure 3. De ce fait, le premier condensateur 61 présente une impédance élevée à une fréquence prédéterminée pour que le courant dans la diode 51 reste dans une plage de valeurs admissibles.

Quand une alternance négative apparaît sur l'émetteur du transistor 18 (au point C) la diode 50 en série avec la résistance 51 sert à décharger la composante continue stockée dans le condensateur 61. Le condensateur 60 présente une valeur faible, par exemple 10 fois plus faible, que celle du condensateur 61.

En alternance positive, la résistance dynamique d'entrée du transistor 18 sur l'émetteur augmente. Mais, la résistance dynamique de la diode 52 diminue parce qu'elle est en conduction. De ce fait, la diode 52 est en parallèle sur le transistor 18 pendant l'alternance positive.

En alternance négative, la résistance dynamique d'émetteur du transistor 18 diminue et la diode 50, en série avec la résistance 51 de valeur élevée par rapport à la résistance dynamique d'émetteur (donc du réseau à corriger) du transistor 18, décharge la composante continue stockée dans le condensateur 61.

Dans un exemple de réalisation, on a mesuré un affaiblissement du second harmonique de 40dB par rapport au premier harmonique.

Le condensateur conserve sa fonction de moyen de prélèvement dans la boucle de rétroaction. De plus, il sert à couper la composante continue.

Dans un mode de réalisation l'oscillateur harmonique de l'émetteur de télécommande comporte un dispositif de linéarisation et de symétrisation qui est constitué selon l'enseignement de la figure 4. Dans un tel montage, un second transistor identique au transistor 18 est monté en amplificateur différentiel dans la boucle de rétroaction entre les deux condensateurs 24 et 25 du circuit résonateur 39 et à la place de la liaison capacitive 22.

Dans un mode de réalisation représenté au dessin, l'alimentation du montage est assurée par un dispositif 5 de sortie, représenté à la figure 7 à travers une inductance de liaison 27. Cette inductance est montée en parallèle avec une résistance 28 de façon à réduire le gain du montage pour qu'il ne résonne pas avec l'inductance de choc 27.

A la Figure 8, on a représenté un oscillateur harmonique constitué sur un oscillateur de type Colpits. Il est possible d'utiliser d'autres structures résonnants, en particulier en composant la structure Colpits avec un oscillateur à cristal comme selon la figure 8, ou encore en utilisant un pont de réactances, une structure Hartley ou un réseau à retard de phase.

Dans ce cas, on dimensionne l'un des éléments du circuit résonnant de façon à constituer un filtre passe-bas dont la fréquence de coupure est comprise entre l'harmonique 1 et l'harmonique 2.

Dans un mode de réalisation préféré de l'émetteur de télécommande selon l'invention, dans une application radiofréquence, le montage électronique a été constitué en un macrocomposant constitué par un circuit imprimé de type "4 couches", enrobé dans une résine et muni de connecteurs pour son alimentation électique et la sortie de son antenne de rayonnement.

Les deux couches extérieures du macrocomposant conservent leur couche conductrice avec en variante un moyen d'adaptation d'impédance de façon à réduire le rayonnement électromagnétique parasite et la susceptibilité magnétique. Elles constituent un blindage et un radiateur de chaleur.

Les deux couches intérieures protégées par les deux couches de blindage portent les pistes conductrices ainsi que les divers composants prévus pour l'émetteur. L'ensemble comporte ses connecteurs de contrôle électrique, de testage et de diagnostic pour permettre la mise au point de prototypes notamment, ainsi que la sortie du signal et les entrées de commande comme l'entrée 17.

Le niveau émis est régulé par les diodes 50 et 51 et de ce fait, il n'y a pas besoin de reprendre le schéma de l'émetteur à chaque implémentation dans un système de communications ou de télécommande. L'émetteur de l'invention est ainsi conçu comme un composant (ou macrocomposant) configurable de l'extérieur par l'utilisateur professionnel.

Il est clair que l'émetteur de télécommande peut être utilisé comme transmetteur de signaux sinusoïdaux sur un canal quelconque comme :
- une liaison hertzienne, ainsi qu'il est décrit à la figure 7 ;
- une liaison filaire, sur câble blindé, sur câble coaxial, sur paires torsadées, etc ;
- une liaison optique utilisant ou non un guide d'ondes, de type acoustique, optique dans le visible ou dans l'infrarouge, etc, pour les applications précitées.

## Revendications

1. Montage électronique, caractérisé en ce qu'il comporte dans l'un de ses réseaux d'entrée ou de sortie, ou dans un chemin de rétroaction entre ses deux réseaux un dispositif linéarisateur et symétriseur (50 - 52 ; 55 - 59) constitué par deux composants (52, 50) dont les fonctions de transfert sont sensiblement inverses l'une de l'autre et qui sont connectées de façon à ce que la fonction de transfert résultante présente près du point de fonctionnement (V0, I0) du montage un point d'inflexion autour duquel une plage linéaire est produite.

2. Montage selon la revendication 1, caractérisé en ce que le dispositif linéarisateur et symétriseur comporte un moyen de prélèvement (7) du signal à transformer sur un point prédéterminé (A) du montage électronique de façon ou bien de sélectionner tout le signal ou une partie de celui-ci ou bien de réaliser les adaptations nécessitées par l'introduction du dispositif dans le montage.

3. Montage selon la revendication 2, caractérisé en ce que la sortie du moyen de prélèvement (7) est connectée à l'entrée d'un premier composant (8) qui est représenté par une première fonction de transfert avec une caractéristique, comme une caractéristique tension-courant, déterminée ; en ce que la sortie du premier composant (8) est connectée à l'entrée d'un second composant (9) qui est représenté par une seconde fonction de transfert avec une caractéristique, comme une caractéristique tension-courant, déterminée ; en ce que la sortie du second composant (9) est réinjectée à un point(B) prédéterminé du montage.

4. Montage selon la revendication 3, caractérisé en ce que la caractéristique tension-courant du premier composant (8) affecte une forme monotone croissante dont la dérivée dI/dV augmente avec V, et en ce que la caractéristique tension-courant du second composant (9) affecte une forme monotone croissante dont la dérivée dI/dV diminue avec V, de façon à ce que, en connectant de manière convenable les deux composants (8 et 9), la caractéristique tension-courant résultante présente un point d'inflexion au lieu où les effets des deux composants s'équilibrent, et on se trouve au centre d'une zone sensiblement linéaire de la caractéristique comprise entre les tensions (V1, V2) et les courants correspondants (i1, i2).

5. Montage selon la revendication 4, caractérisé en ce que les deux extrémités de la caractéristique résultante présentent une pente réduite ou nulle qui produit un effet d'écrêtage qui limite les distorsions de façon automatique.

6. Montage selon la revendication 2, caractérisé en ce que les deux composants (8, 9) sont choisis de manière réciproque, comme deux diodes montées en inverse l'une de l'autre, ou comme une diode et une jonction base-émetteur, de façon à obtenir une réponse symétrique de part et d'autre du point d'inflexion (v0, i0).

7. Montage selon la revendication 2, caractérisé en ce que le dispositif linéarisateur et symétriseur comporte :
- un premier composant constitué par une diode (50) dont l'anode est connectée à une première borne d'une résistance (51) et dont la cathode est connectée à une entrée (A) ;
- un second composant constitué par une diode (52), identique à la première diode (50), et connectée dans le sens inverse de celui de la première diode entre la masse et une sortie (B) ;
sortie et entrée étant reliées ensemble.

8. Montage selon la revendication 2, caractérisé en ce que le dispositif linéarisateur et symétriseur comporte :
- un premier composant constitué par un transistor (55) de type NPN ajouté à un transistor NPN sensiblement identique, et déjà existant dans le montage électronique,
- un second composant (T) constitué par le transistor déjà existant ;
de telle sorte que les deux transistors (55, T) sont montés en différentiel pour présenter une jonction émetteur-collecteur en inverse de la jonction émetteur-collecteur du transistor existant (T).

9. Oscillateur comme un oscillateur harmonique, du type comportant :
- un étage amplificateur (2) ;
- un réservoir d'énergie résonnant comme un circuit accordé (3)
- une boucle de rétroaction (4) qui renvoie une fraction prédéterminée de l'énergie stockée à l'entrée de l'amplificateur (2), caractérisé en ce que la boucle de rétroaction comporte un dispositif de linéarisation et de symétrisation selon l'une des revendications précédentes.

10. Oscillateur selon la revendication 9, caractérisé en ce qu'une partie du circuit accordé (3) constitue un filtre passe-bas (6) dont la sortie constitue la sortie (5) de l'oscillateur.

11. Oscillateur harmonique selon la revendication 9 ou 10, caractérisé en ce qu'il est de type Hartley, le filtre passe-bas, s'il est implanté, étant constitué par un premier condensateur du résonateur, l'inductance du résonateur et un condensateur de filtrage.

12. Oscillateur harmonique selon la revendication 9 ou 10, caractérisé en ce qu'il est de type Colpits, le filtre passe-bas, s'il est implanté, étant un filtre en "PI", constitué par un premier condensateur (24) du résonateur, l'inductance (23) du résonateur et un condensateur de filtrage (26), connecté à la masse électrique.

13. Oscillateur harmonique selon la revendication 10, caractérisé en ce que la boucle de rétroaction est connectée entre la sortie du circuit résonnant et la base d'un transistor d'entrée de l'amplificateur.

14. Oscillateur harmonique selon la revendication 10, caractérisé en ce que la boucle de rétroaction est connectée entre la sortie du circuit résonnant et l'émetteur d'un transistor de l'amplificateur.

15. Oscillateur harmonique selon la revendication 10, caractérisé en ce que le circuit résonnant (3) est alimenté par l'intermédiaire d'une inductance de choc (27).

16. Oscillateur harmonique selon la revendication 15, caractérisé en ce que l'inductance de choc (27) est connectée dans un dispositif (5) permettant de réduire le gain de l'oscillateur de façon à ce qu'il ne résonne pas sur l'inductance de choc (27), dispositif (5) pouvant être constitué par une résistance (28) connectée en parallèle sur l'inductance de choc (27).

17. Emetteur de télécommande, destiné notamment à faire fonctionner à distance un appareil doté d'un récepteur convenable, en particulier de type radiofréquence, caractérisé en ce qu'il comporte un générateur de signal de modulation (11 - 15) dont la sortie (15) est connectée à l'entrée (17) de l'amplificateur (18) d'un oscillateur harmonique (16), dont la sortie (27, 28) est couplée à un organe rayonnant comme une antenne radiofréquence (29), caractérisé en ce que l'oscillateur harmonique est constitué selon l'une des revendications précédentes.

18. Emetteur selon la revendication 17, caractérisé en ce que, dans une application radiofréquence, le montage électronique a été constitué en un macrocomposant constitué par un circuit imprimé de type "4 couches", enrobé dans une résine et muni de connecteurs pour son alimentation électique et la sortie de son antenne de rayonnement ;
les deux couches extérieures du macrocomposant conservent leur couche conductrice avec en variante un moyen d'adaptation d'impédance de façon à réduire le rayonnement électromagnétique parasite et la susceptibilité magnétique pour constituer un blindage et un radiateur de chaleur ;
les deux couches intérieures protégées par les deux couches de blindage portent les pistes conductrices ainsi que les divers composants prévus pour l'émetteur ; l'ensemble comportant ses connecteurs de contrôle électrique, de testage et de diagnostic pour permettre la mise au point de prototypes notamment, ainsi que la sortie du signal et les entrées de commande comme l'entrée 17 ;
le niveau émis étant régulé par les diodes 50 et 51.
